# EUROPÄISCHE PATENTSCHRIFT

(11) **EP 1 409 251 B1**
(45) Veröffentlichungstag und Bekanntmachung des Hinweises auf die Patenterteilung: **28.12.2011**
(21) Anmeldenummer: 02753002.1
(22) Anmeldetag: 09.07.2002
(51) Int. Cl.: B41F 15/08, H01L 51/40, G09G 3/32

(54) **KONTINUIERLICHER SIEBDRUCK VON ORGANISCHEN LEUCHTDIODEN**
CONTINUOUS SCREEN PRINTING OF ORGANIC LIGHT-EMITTING DIODES
SERIGRAPHIE CONTINUE DE DIODES LUMINESCENTES ORGANIQUES

(30) Priorität: 13.07.2001 DE 10134132
(43) Veröffentlichungstag der Anmeldung: 21.04.2004
(73) Patentinhaber: OSRAM Opto Semiconductors GmbH, 93055 Regensburg (DE)
(72) Erfinder: BIRNSTOCK, Jan, 04103 Leipzig (DE); BLÄSSING, Jörg, 73447 Oberkochen (DE); HEUSER, Karsten, 91056 Erlangen (DE); WITTMANN, Georg, 91074 Herzogenaurach (DE)
(74) Vertreter: Epping - Hermann - Fischer
(86) Internationale Anmeldenummer: PCT/DE2002/002513
(87) Internationale Veröffentlichungsnummer: WO 2003/006242

(56) Entgegenhaltungen:
- EP-A- 0 724 956
- DE-A- 2 607 929
- DE-A- 19 918 193
- DE-B- 1 220 443
- DE-C- 82 677
- ROGERS J A ET AL.: "Printing process suitable for reel-to-reel production of high-performance organic transistors and circuits" ADVANCED MATERIALS, VCH VERLAGSGESELLSCHAFT, WEINHEIM, DE, Bd. 11, Nr. 9, 5. Juli 1999 (1999-07-05), Seiten 741-745, XP000851834
- PARDO D A; JABBOUR G E; PEYGHAMBARIAN N: "Application of screen printing in the fabrication of organic light-emitting devices " ADVANCED MATERIALS, VCH VERLAGSGESELLSCHAFT, WEINHEIM, DE, Bd. 12, Nr. 17, 1. September 2000 (2000-09-01), Seiten 1249-1252, XP000963603

## Beschreibung

Die Erfindung betrifft eine Vorrichtung und ein Verfahren zum kontinuierlichen Drucken von organischen Leuchtdioden, sogenanten OLEDS.

Organische Leuchtdioden auf Basis von organischem Material wie Polymeren und/oder "small molecules" als Hauptmaterial der Funktionsschichten haben in den letzten Jahren eine rasante Entwicklung genommen. Verbesserte Effizienzen, eine Vielzahl neuer Farben und geringere Einsatzspannungen machen sie für eine ganze Reihe von Einsatzgebieten interessant. Typische Anwendungen können Low-Information-Content Passiv-Matrix-Displays mit einigen Tausend Pixeln und einer Icon-Leiste, Backlights für LCDs oder flächige Beleuchtungselemente sein. Hier kommen die Vorteile der OLEDs, wie die Lambert'sche Abstrahlung und die geringe Dicke zum Tragen.

Im Moment werden die Funktionsschichten aus denen eine OLED besteht (z.B. Poly(1,4-phenylenvinylen), PPV oder Polyfluoren bzw. Derivate dieser Materialien) zumeist mit Hilfe des Drehschleuderverfahrens auf das Glas- oder Foliensubstrat und/ oder auf eine untere und/oder strukturierte Schicht aufgebracht. Dieses Verfahren hat eine Reihe von Nachteilen: Der Großteil der Lösung des Polymers (ca. 98%) geht unwiederbringlich verloren, der Drehschleudervorgang dauert relativ lange (ca. 30 - 60 sec) und bei größeren Substraten ist es nahezu unmöglich homogene Funktionsschichten aufzubringen.

Darum wird nach alternativen Methoden gesucht, organisches Material großflächig aufzubringen. Eine Reihe von Druckverfahren sind dafür geeignet: Siebdruck, Tampondruck, Ink-Jet-Drucken, Hoch- und Tiefdruckverfahren [z.B. D. A. Pardo, G. E. Jabbour, and N. Peyghambrian "Application of Screen Printing in the Fabrication of Organic Light-Emitting Devices"; Adv. Mat., 2000, 17, p. 1249-1252; in dieser Veröffentlichung wird die Verwendung von Siebdruck bei der Herstellung von OLEDs beschrieben. K. Mori et al., "Organic Light-Emitting Devices Patterned by Screen-Prin-ting"; Jpn. J. Appl. Phys., 2000, 39, p. 942-944; Birnstock et al. "Screen-printed passive matrix displays based on light-emitting polymers"; Appl. Phys. Lett., Vol. 78, No. 24, 2001]. Diese Druckmethoden haben außerdem den Vorteil, dass sie es erlauben, das organische Material bereits strukturiert aufzubringen, wodurch multichrome oder vollfarbige OLEDs ermöglicht werden.

Das Dokument DE-C-82677 beschreibt eine Vorrichtung zum Bedrucken langer Bahnen aus Stoff oder Papier mittels endloser Schablonen.

Die Offenlegungsschrift DE 26 07 929 A1 beschreibt eine Siebdruckmaschine mit mindestens zwei Druckwerken, bei der Verstellmittel einer Spannwalze durch Untersetzungsgetriebe bewegbar sind.

Ein Mikro-Kontakt siebdtruckverfahren (microcontact printing) zum Drucken von Source- und Drain-Elektroden auf verschiedenen Substraten wird in Rogers et al., "Printing Process Suitable for Reel-to-Reel Production of High-Performance Organic Transistors and Circuits"; Adv. Mat., 1999, 11, No. 9, p. 741-745; offenbart.

Während bislang ein Großteil der Prozesse für Glassubstrate entwickelt wurden, gewinnen in Zukunft auch flexible Substrate (z.B. Folien) immer mehr Bedeutung.

Aufgabe der Erfindung ist es, eine Vorrichtung und ein Verfahren zum Aufbringen von löslichem organischem Material, insbesondere von Polymeren auf flexible Substrate, zu schaffen, die bzw. das kontinuierlich arbeitet.

Die Substrate sollen aus ökonomischen Gründen nicht mehr im "Stop-and-Go"-Verfahren bedruckt werden, wie beim klassischen Druck auf Glassubstrate, sondern in einem kontinuierlichen Verfahren mit Bandmaterial beispielsweise "auf einer Rolle" beschichtet werden. Das, unter Umständen vorstrukturierte, Foliensubstrat liegt dabei aufgewickelt auf einer Rolle vor und soll mit einem oder mehreren Polymeren bedruckt werden, während die Folie in einer gleichmäßigen Bewegung von der Rolle abgespult wird.

Die Aufgabe wird durch eine Vorrichtung gemäß Anspruch 1 und durch ein Verfahren gemäß Anspruch 5 gelöst, indem ein spezielles Sieb-druckverfahren zum Drucken der OLEDs zum Einsatz kommt.

Es wird eine Vorrichtung zum kontinuier-lichen Bedrucken eines Substrat-Bandmaterials mittels Sieb-druck angegeben, die zumindest ein Drucksieb umfasst und bei der das Substrat-Bandmaterial auf einer Rolle vorliegt, wobei eine Einrichtung zur Bewegung des Drucksiebs vorgesehen ist, die bewirkt, dass es das Bandmaterial während des Bedruckens begleiten kann und nach dem Drucken wieder an seine Ausgangsposition zurückgeführt wird.

Es wird eine OLED angegeben, die zumindest eine Funktionsschicht, die mittels Siebdruck im kontinuierlichen Verfahren aufgebracht wurde, umfasst.

Weiterhin wird ein Verfahren zum Bedrucken eines Substrat-Bandmaterials mittels Siebdruck angegeben, bei dem das Substrat an zumindest einem Sieb vorbeigeführt wird, wobei das Sieb das Bandmaterial während des Bedruckens begleitet.

Der Begriff Substrat-Bandmaterial bezeichnet bevorzugt flexible Substrate wie Folien die in Bandform vorliegen. Das Substrat dient als Träger einer OLED.

Nach einer vorteilhaften Ausgestaltung umfasst die Vorrichtung eine Reihe von gleich wirkenden Sieben, die jeweils hintereinandergeschaltet sind und aufeinanderfolgende Bereiche des Bandmaterials wahrend des Druckens begleiten. Insbesondere ist die Reihe von Sieben eines organischen Materials und/oder einer Schablone so angeordnet, dass keine unbrauchbaren, weil unbedruckten Stellen auf dem Bandmaterial entstehen. Das Band wird damit nahezu zu 100% ausgenutzt und ein Schnitt des fertig beschichteten Bandes erzeugt zwei Kanten zweier Substrate.

Nach einer Ausführungsform druckt die Vorrichtung mit einer Präzision, die typischerweise nur einige Dutzend µm Toleranz erlaubt.

Nach einer Ausführungsform des Verfahrens wird das Substrat-Bandmaterial mit einer typischen Geschwindigkeit von 0,5 m/s, bevorzugt im Bereich von 0,25 bis 1 m/s bedruckt.

Bandbreiten liegen vorzugsweise und je nach Anwendung bei 50 bis 500 mm.

Nach einer vorteilhaften Ausführungsform der Vorrichtung sind mehrere verschieden wirkende Siebe oder Siebreihen hintereinandergeschaltet, so dass eine komplette OLED in einer Vorrichtung hergestellt werden kann.

Typischerweise hat ein Substrat-Bandmaterial eine Dicke von 0,005 bis 1 mm und eine Bandbreite von 50 bis 500 mm.

Es kann auch vorteilhaft sein, dass ein gewisser Abstand von einem bedruckten Bereich zum nächsten auf dem Substrat-Bandmaterial erwünscht ist, so dass eine Vorrichtung ohne Siebreihen, die pro Druckteilschritt nur ein Sieb hat, durchaus einer Vorrichtung mit Siebreihen, also mehreren gleich wirkenden Sieben pro Druckteilschritt, vorzuziehen ist. Es kann auch vorgesehen sein, dass bei einer Vorrichtung mehrere Siebe einer Siebreihe variabel einsetzbar oder parkbar sind, das heißt, dass sie je nach Anforderung zum Einsatz kommen oder nicht.

Außer den Sieben mit Schablone, Rakel und Tank für die Lösung organischem Materials kann in der Vorrichtung noch eine Einrichtung zur Bestrahlung UV-härtbarer Funktionsschichten, eine Heizung, ein Gebläse, Bestreuer und/oder eine sonstige Einrichtung zur Produktion eines OLEDs mitumfasst sein.

Am Ausgang der Vorrichtung, wo das fertig bedruckte Bandmaterial die Vorrichtung verlässt, ist bei einer Ausführungsform eine Schneide- und/oder Stanzeinrichtung zur Abtrennung und/ oder Verkapselung der einzelnen OLEDs vorgesehen.

Sonstige Elemente, wie die Einrichtung zum Abrollen des Substrat-Bandmaterials sowie zur Erhaltung der erforderlichen Bahnspannung sind von der Vorrichtung mitumfasst und gehören zum Stand der Technik, weshalb sie hier nicht in allen Einzelheiten beschrieben werden.

Das Bedrucken einer sich gleichförmig bewegenden Folie ist nicht trivial, da die klassischen "Rolle-auf-Rolle"-Prozesse (Offsetdruck, ...) nicht in Frage kommen. Kritisch sind hier nämlich die Fotolackstrukturen, die sich bereits auf der Folie befinden. Sie werden durch diese Kontaktverfahren entweder zerstört oder verhindern einen Übertrag der Polymerlösung. Durch das herkömmliche "stop and go" Prozedere beim Bedrucken wird die Substratfolie unnötig gestresst, was beim kontinuierlichen Verfahren nicht der Fall ist.

Der Vorteil des Verfahrens ist außerdem die hohe Geschwindigkeit und die große Präzision, mit der OLEDs hergestellt werden können.

Im folgenden wird die Erfindung anhand eines Ausführungsbeispiels näher erläutert:

Die Herstellung eines flexiblen, monochromatischen Displays auf Basis organischer Leuchtdioden mittels der speziellen Siebdrucktechnik "Sieb-auf-Rolle":

Eine transparente und für Wasser und Sauerstoff undurchlässige Folie ist strukturiert mit ITO (Indium Zinn Oxid) beschichtet und mit Fotolackstrukturen versehen. Die Fotolackstrukturen dienen zur Separierung der einzelnen Kathodenbahnen und zum Confinement der gedruckten Polymerflächen. Diese Prozessierungen sind bekannt und gut verstanden. Durch die Vorstrukturierung der Folie werden Hunderte einzelner Passiv-Matrix-Displays definiert. Die Folie liegt auf einer Rolle aufgewickelt vor. Mit Hilfe der speziellen Siebdruckmaschine werden nun nacheinander mehrere konjugierte Polymere auf die Folie gedruckt und in geeigneter Weise getrocknet. Bei diesem Druckverfahren kann die Folie in einer gleichmäßigen Bewegung durch die Maschine geführt werden. Abschließend wird strukturiert (z.B. über Schattenmasken) eine Kathode aufgedampft und die Folie auch von der aktiven Seite wasser- und luftdicht versiegelt. Nun können die einzelnen Displays ausgeschnitten und kontaktiert werden.

Die Erfindung betrifft eine Vorrichtung und ein Verfahren zum kontinuierlichen Drucken von organischen Leuchtdioden (OLEDs). Dabei wird ein Substrat mit oder ohne Beschichtung als Bandmaterial auf einer Rolle vorgelegt und durch eine Vorrichtung mit beweglichen Sieben zum Bedrucken mittels Siebdruck durchgeführt.

## Patentansprüche

1. Vorrichtung für die Herstellung von OLEDs, bei der mittels Siebdruck ein Substrat-Bandmaterial kontinuierlich mit mindestens einer Funktionsschicht bedruckt wird , umfassend eine Druckvorrichtung und mindestens eine weitere Einrichtung für die Herstellung der OLED,
wobei die Druckvorrichtung zumindest ein Drucksieb umfasst und bei der Druckvorrichtung das Substrat-Bandmaterial auf einer Rolle vorliegt, wobei eine Einrichtung zur Bewegung des Drucksiebs vorgesehen ist, die bewirkt, dass es das Bandmaterial während des Bedruckens begleiten kann und nach dem Drucken wieder an seine Ausgangsposition zurückgeführt wird, und
wobei die mindestens eine weitere Einrichtung für die Herstellung der OLED ausgewählt wird aus einer Einrichtung zur Bestrahlung UV-härtbarer Funktionsschichten, einer Heizung, einem Gebläse, einem Bestreuer, einer Einrichtung zum Aufbringen von Fotolackstrukturen, einer Einrichtung zum strukturierten Aufdampfen einer Elektrode und einer Einrichtung zum wasser- und luftdichten Versiegeln des Substrat-Bandmaterials.

2. Vorrichtung nach Anspruch 1, die eine Reihe von gleich wirkenden Sieben umfasst.

3. Vorrichtung nach einem der vorstehenden Ansprüche bei der zumindest zwei verschieden wirkende Siebe oder Siebreihen hintereinandergeschaltet sind.

4. Vorrichtung nach einem der vorstehenden Ansprüche, bei der eine Schneide- und/oder Stanzeinrichtung zur Abtrennung und/oder Verkapselung der einzelnen OLEDs vorgesehen ist.

5. Verfahren zur Herstellung organischer Leuchtdioden, bei dem ein Substrat-Bandmaterials mit mindestens einer Funktionsschicht der OLED mittels Siebdruck bedruckt wird, wobei das Substrat an zumindest einem Sieb vorbeigeführt wird, wobei das Sieb das Bandmaterial während des Bedruckens begleitet.

6. Verfahren nach dem vorhergehenden Anspruch, wobei das Substrat-Bandmaterial mit einer typischen Geschwindigkeit von 0,5 m/s bedruckt wird.

7. Verfahren nach einem der beiden vorhergehenden Ansprüche, wobei die das Sieb enthaltende Druckvorrichtung mit einer Präzision, die typischerweise nur einige Dutzend µm Toleranz erlaubt, druckt.

## Claims

1. Device for producing OLEDs, in which a substrate strip material is continuously imprinted with at least one functional layer by means of screen printing, comprising a printing device and at least one further device for producing the OLED,
wherein the printing device comprises at least one printing screen and, in the printing device, the substrate strip material is on a roll, a device for moving the printing screen being provided, with the effect that it can accompany the strip material during the imprinting and is returned again to its starting position after the printing, and
wherein the at least one further device for producing the OLED is chosen from a device for irradiating UV-curable functional layers, a heater, a blower, a sprinkler, a device for applying photoresist structures, a device for a structured vapour-deposition of an electrode and a device for sealing the substrate strip material in a watertight and airtight manner.

2. Device according to Claim 1, which comprises a series of identically acting screens.

3. Device according to one of the preceding claims, in which at least two differently acting screens or rows of screens are arranged one behind the other.

4. Device according to one of the preceding claims, in which a cutting and/or punching device is provided for detaching and/or encapsulating the individual OLEDs.

5. Method for producing organic light-emitting diodes, in which a substrate strip material is imprinted with at least one functional layer of the OLED by means of screen printing, wherein the substrate is guided past at least one screen, the screen accompanying the strip material during the imprinting.

6. Method according to the preceding claim, wherein the substrate strip material is imprinted at a typical rate of 0.5 m/s.

7. Method according to one of the two preceding claims, wherein the printing device comprising the screen prints with a precision which typically allows a tolerance of only a few dozen µm.

## Revendications

1. Dispositif destiné à la fabrication d'OLED, dans lequel un matériau de substrat en bande est imprimé en continu par sérigraphie avec au moins une couche fonctionnelle, comprenant un dispositif d'impression et au moins un autre dispositif pour la fabrication des OLED,
dans lequel le dispositif d'impression comprend au moins un écran d'impression et le matériau de substrat en bande est disponible sur un rouleau dans le dispositif d'impression, un dispositif destiné à déplacer l'écran d'impression étant prévu, lequel fait en sorte qu'il puisse accompagner le matériau en bande pendant l'impression et soit renvoyé à sa position de départ après l'impression, et
dans lequel l'au moins un autre dispositif destiné à la fabrication des OLED est choisi parmi un dispositif d'irradiation de couches fonctionnelles durcissables aux UV, un chauffage, une soufflante, un diffuseur, un dispositif d'application de structures de vernis photo, un dispositif de dépôt en phase vapeur structuré d'une électrode et un dispositif de scellement étanche à l'eau et à l'air du matériau de substrat en bande.

2. Dispositif selon la revendication 1, qui comprend une rangée d'écrans agissant de la même manière.

3. Dispositif selon l'une des revendications précédentes, dans lequel au moins deux écrans ou rangées d'écrans agissant différemment sont monté(e)s l'un(e) derrière l'autre.

4. Dispositif selon l'une des revendications précédentes, dans lequel un dispositif de coupe et/ou d'estampage est prévu pour séparer et/ou encapsuler les différentes OLED.

5. Procédé de fabrication de diodes électroluminescentes organiques, dans lequel un matériau de substrat en bande est imprimé par sérigraphie avec au moins une couche fonctionnelle de l'OLED, le substrat passant devant au moins un écran, l'écran accompagnant le matériau en bande pendant l'impression.

6. Procédé selon la revendication précédente, dans lequel le matériau de substrat en bande est imprimé à une vitesse type de 0,5 m/s.

7. Procédé selon l'une des deux revendications précédentes, dans lequel le dispositif d'impression comprenant l'écran imprime avec une précision qui ne permet typiquement que quelques douzaines de µm de tolérance.
